# FASCICULE DE BREVET EUROPEEN

(11) **EP 0 318 404 B1**
(45) Date de publication et mention de la délivrance du brevet: **23.03.1994**
(21) Numéro de dépôt: 88420392.8
(22) Date de dépôt: 24.11.1988
(51) Int. Cl.: H01L 27/08, H01L 29/90

(54) **Assemblage monolithique de diodes de protection et systèmes de protection**
Monolithische Schutzdiodenmontage und Schutzsysteme
Monolithic protection diode assembly and protection systems

(30) Priorité: 24.11.1987 FR 8716605
(43) Date de publication de la demande: 31.05.1989
(73) Titulaire: SGS-THOMSON MICROELECTRONICS S.A., 94250 Gentilly (FR)
(72) Inventeur: Pezzani, Robert, F-37210 Vouvray (FR); Jeudi, Patrice, Par la Membrolle (37) (FR)
(74) Mandataire: de Beaumont, Michel

(56) Documents cités:
- EP-A- 0 148 577
- EP-A- 0 186 567
- FR-A- 2 433 845
- US-A- 4 216 488
- PATENT ABSTRACTS OF JAPAN, vol. 9, no. 302 (E-362)[2025], 29 novembre 1985, page 115 E 362; & JP-A-60 140 878

## Description

La présente invention concerne des systèmes de protection pour protéger des lignes à plusieurs conducteurs telles que les lignes de transmission utilisées dans des systèmes informatiques entre une unité centrale et des postes d'utilisation (terminaux, imprimantes, etc).

Dans de telles transmissions multilignes, il convient de prévoir des dispositifs pour protéger chacune des lignes contre d'éventuelles surtensions positives ou négatives par rapport à une masse. Pour ce faire, on utilise des dispositifs de protection, couramment appelés diodes, présentant une tension de claquage déterminée tant dans le sens positif que dans le sens négatif. Un exemple d'un tel montage est illustré en figure 1 où l'on peut voir des lignes L1, L2... Ln reliées à une masse M par des diodes D1, D2... Dn.

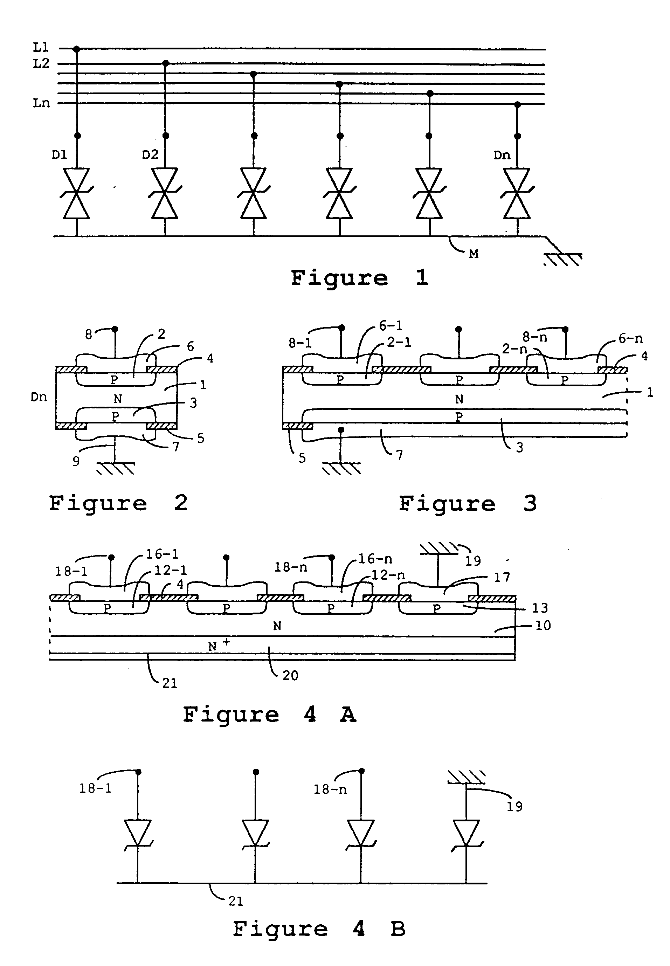

La figure 2 représente un exemple d'une telle diode à claquage bidirectionnel Dn qui comprend, dans un substrat 1 de silicium de type N, des zones de types de conductivité opposés 2 et 3 formées à partir des deux faces opposées à travers des masques de silice 4 et 5. Chacune des faces de la diode est reliée par une métallisation respective 6, 7 à une borne de sortie 8, 9, la borne 8 étant reliée à la ligne à protéger et la borne 9 à un potentiel de référence, habituellement le potentiel de la masse.

Ainsi, s'il y a huit lignes à protéger, huit dispositifs tels que celui représenté en figure 2 devront être prévus. Chacun de ces dispositifs est inclus dans un boîtier et il est bien connu dans le domaine de la fabrication des semiconducteurs que le coût de mise en boîtier d'un dispositif semiconducteur est loin d'être négligeable, s'il n'est pas prépondérant, par rapport au coût du dispositif semiconducteur lui-même.

Ainsi, dans un premier effort de réduction des coûts, dans le cas où il y a huit lignes à protéger, on a essayé de mettre les huit puces dans un même boîtier. Ceci constitue une première source d'économie mais ne constitue pas une solution idéale car le coût d'assemblage des puces dans le boîtier est relativement élevé, le rendement d'assemblage est faible car un défaut de montage sur une seule puce entraîne un rejet du système d'ensemble et la fiabilité est faible car un défaut dans une seule puce ou son montage entraîne un défaut sur l'ensemble du système.

On est donc conduit à rechercher une solution d'intégration monolithique pour limiter le nombre de puces à assembler.

On montrera ci-après que les solutions directes d'intégration monolithique qui pourraient apparaître ne permettent pas de résoudre divers problèmes tels que le passage de courants importants dans la diode de protection, la réduction des capacités statiques, et des éventuels claquages entre lignes plutôt qu'entre une ligne et la masse.

La demande de brevet français FR-A-2 433 845 décrit un assemblage monolithique de thyristors sans gâchette associés à des diodes anti-parallèles.

La présente invention vise à prévoir un système de protection à une ou deux puces permettant d'éviter les inconvénients susmentionnés.

Pour atteindre ces objets, la présente invention prévoit un assemblage monolithique de diodes de protection formé dans un substrat semiconducteur d'un premier type de conductivité tel que la première face du substrat comprend des zones discrètes du deuxième type de conductivité opposé au premier dont une première zone est reliée à un potentiel de référence et les autres zones forment avec le substrat des diodes et sont reliées à des bornes destinées à être connectées à des circuits à protéger, au moins la première zone formant avec le substrat une diode à avalanche, et que la deuxième face du substrat est uniformément surdopée selon le premier type de conductivité et revêtue d'une métallisation dont le potentiel est flottant.

Selon un autre aspect de la présente invention, il est prévu un montage de protection comprenant deux tels assemblages monolithiques connectés en parallèle dans lesquels les types de conductivité des zones correspondantes sont mutuellement inversés, les bornes correspondantes étant reliées les unes aux autres sauf les métallisations flottantes.

Selon un mode de réalisation de ce montage de protection, parmi lesdites zones discrètes, celle reliée au potentiel de référence est dopée de façon à former avec le substrat une diode à avalanche de tension de claquage déterminée, et celles reliées auxdites bornes sont dopées pour former avec le substrat des diodes redresseuses à tension de claquage en inverse plus élevée que ladite tension de claquage déterminée.

Plus particulièrement, ce montage de protection peut être tel que les zones reliées aux bornes sont formées par une première étape de diffusion suivie d'une deuxième étape de diffusion à densité de dopant plus élevée au cours de laquelle on forme simultanément la zone reliée au potentiel de référence. Un autre mode de réalisation d'un montage est décrit dans la revendication 4. Un procédé pour fabriquer un montage est décrit dans la revendication 5.

Ces objets, caractéristiques et avantages ainsi que d'autres de la présente invention seront exposés plus en détail dans la description suivante de modes de réalisation particuliers faite en relation avec les figures jointes parmi lesquelles :
la figure 1 représente un montage classique de diodes de protection connectées à des lignes à protéger ;
la figure 2 représente un exemple de diode de protection classique ;
la figure 3 représente une réalisation de diodes de protection intégrées ;
la figure 4A représente un premier mode de réalisation de diodes de protection intégrées selon la présente invention ;
la figure 4B représente un schéma équivalent du circuit intégré de la figure 4A ;
la figure 5A représente un montage de protection à deux puces selon la présente invention ;
la figure 5B représente un schéma équivalent du montage de la figure 5A ; et
les figures 6 et 7 représentent des exemples en vue de dessus de diodes de protection intégrées selon la présente invention.

La figure 3 représente un exemple d'assemblage monolithique de diodes de protection directement déduit de la structure de diode illustrée en figure 2. On peut voir en figure 3, un substrat semiconducteur 1 d'un premier type de conductivité (type N), par exemple du silicium. Dans la surface supérieure de ce substrat sont formées des zones diffusées 2-1 ... 2-n de type P à travers un masque d'oxyde 4. Chacune des zones diffusées est recouverte d'une métallisation 6-1 ...6-n reliée à une borne 8-1 ...8-n destinée à assurer la connexion vers les lignes à protéger. Sur l'autre face du substrat est prévue une région diffusée 3 de type P, éventuellement formée simultanément avec les régions 2-1 ...2-n et revêtue d'une métallisation 7.

Cette structure se comporte sensiblement comme un montage de n diodes telles que celle de la figure 2 montées en parallèle avec tous les inconvénients de cette diode et des inconvénients supplémentaires.

Un inconvénient commun aux diodes des figures 2 et 3 est qu'il est inévitable que l'épaisseur de substrat 1 soit relativement importante ce qui limite lors de la mise en avalanche le courant traversant la diode.

Un inconvénient de la diode intégrée de la figure 3 est que la capacité statique de cette diode, quand elle est en blocage, est relativement importante du fait de la grande surface de la jonction inférieure.

Un inconvénient supplémentaire apporté par l'intégration est que, alors que dans le montage non intégré la tension de claquage entre deux lignes quelconques connectées à deux diodes Dn distinctes est égale à deux tensions d'avalanche, d'où il résulte qu'il est fort peu probable qu'il se produise un claquage entre lignes plutôt qu'un claquage vers la masse, par contre, avec une réalisation intégrée telle que celle de la figure 3, la tension de claquage entre deux lignes est identique à la tension de claquage entre une ligne et la masse. Ceci peut, dans certaines configurations, provoquer un claquage entre lignes avant un claquage entre une ligne et la masse et peut être destructif pour les composants connectés aux lignes concernées.

Un autre inconvénient du mode d'intégration illustré en figure 3 est que le dispositif obtenu doit présenter plusieurs bornes de connexion sur une face et une connexion supplémentaire sur la face opposée. Ceci implique l'utilisation de procédés de connexion relativement complexes d'autant plus que la métallisation 7 sur la face inférieure est généralement non plane, et présente, comme le montre par exemple la figure, une surépaisseur aux limites de la zone de diffusion (au dessus des limites du masque 5 d'oxyde).

La figure 4A représente un exemple de structure monolithique selon la présente invention. Cette structure comprend une couche 10 d'un premier type de conductivité, par exemple N. Sur la face supérieure de cette couche 10 sont formées des zones diffusées 12-1 ...12-n de type P correspondant aux zones 2-1 ...2-n de la figure 3, revêtues de métallisations 16-1 ...16-n connectées à des bornes 18-1 ...18-n. En outre, sur la même face du substrat est formée une zone diffusée 13 du même type de conductivité P revêtue d'une métallisation 17 et connectée à une borne de potentiel de référence 19, couramment la masse. La face inférieure du substrat comprend une couche surdopée 20 du même type de conductivité N que la couche 10. Cette couche 20 est revêtue d'une métallisation 21. La figure 4B représente un schéma équivalent du circuit intégré de la figure 4A dans lequel on peut voir les bornes 18-1 à 18-n et 19 reliées par des diodes à avalanche à une connexion commune qui correspond à la métallisation 21.

Par rapport au circuit intégré de la figure 3, le circuit intégré de la figure 4A présente l'avantage d'une réduction de la capacité statique à une valeur sensiblement moitié. Un autre avantage de ce circuit monolithique est que la jonction de la diode reliée à la masse étant identique à la jonction des diodes reliées aux lignes, le dispositif est normalement parfaitement symétrique que le claquage soit dû à une surtension positive ou à une surtension négative. Un autre avantage de cette disposition est que la couche surdopée 20 peut être épaisse et la largeur de la couche 10 réduite, ce qui permet de limiter la résistance en direct de la couche de substrat 10. Lors d'un claquage, une conduction s'établit entre l'une des métallisations 16-1 à 16-n dans la zone située en face de la métallisation 21 jusqu'à cette métallisation. Ensuite, le courant est transmis avec une très faible perte ohmique par la métallisation 21 jusqu'à la zone en regard de la région diffusée 13 où il se produit à nouveau une conduction transverse au travers des couches 20 et 10.

Un autre avantage du montage selon la présente invention est que la métallisation inférieure 21 doit rester flottante, c'est-à-dire qu'elle n'est connectée à aucune borne extérieure. Ainsi, toutes les bornes d'accès au circuit intégré sont sur une même face, ce qui simplifie la mise en boîtier.

Ainsi, la disposition de la présente invention, telle que celle de la figure 4A, permet de résoudre des inconvénients du montage discret de la figure 2 et d'un circuit intégré tel que celui de la figure 3 mais il demeure néanmoins un inconvénient qui existait dans le circuit intégré de la figure 3 à savoir que la tension de claquage entre deux lignes est identique à la tension de claquage entre une ligne et la masse. Il peut en résulter des claquages entre lignes dans certaines configurations.

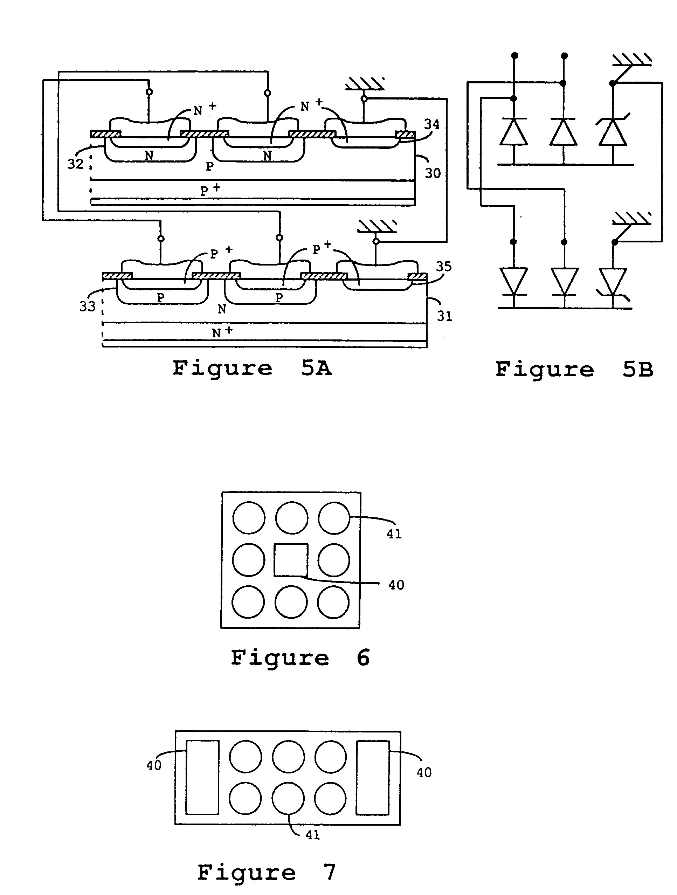

Pour résoudre cet inconvénient, la présente invention prévoit un montage de protection tel que celui illustré en figures 5A et 5B qui utilise deux puces monolithiques analogues à celle de la figure 4 montées en parallèle et dont les types de conductivité sont inversés. La figure 5B représente un schéma équivalent du circuit de la figure 5A. Ce circuit présente l'avantage que l'on élimine la possibilité de claquage entre lignes plutôt qu'entre ligne et masse.

Si l'on considère le schéma de la figure 5B, on notera qu'avec un tel montage en parallèle, il n'est plus nécessaire que les diodes reliées aux lignes soient des diodes à avalanche mais qu'il suffit que ce soient des diodes redresseuses, étant donné que la caractéristique de claquage en positif ou en négatif vers la masse est assurée par les diodes à avalanche reliées à la masse.

A la figure 5A, on peut voir un mode de réalisation qui permet d'obtenir pour les diodes reliées aux lignes des diodes redresseuses simples, c'est-à-dire des diodes présentant une tension de claquage bien supérieure à celle de la diode à avalanche reliée à la masse de chacun des circuits 30 et 31. Ainsi, on peut voir en figure 5A que les régions 32 et 33 du type de conductivité opposé à celui du substrat, par exemple de type N dans la puce 30 et P dans la puce 31, sont constituées de diffusions successives de même type de conductivité réalisées à l'intérieur d'une même ouverture. La première diffusion plus profonde est réalisée seulement dans les zones des diodes connectées aux lignes alors que la seconde diffusion, de plus fort niveau de dopage et de plus faible profondeur, est réalisée simultanément dans les zones des diodes connectées aux lignes et des diodes 34 et 35 reliées à la masse, pour assurer la tension de claquage satisfaisante au niveau de la diode reliée à la masse et pour assurer un surdopage de contact ohmique au niveau des diodes connectées aux lignes. Les deux puces de la figure 5A pourront facilement être montées sur une plaquette isolante, par exemple en céramique, elle-même brasée sur le fond d'un boîtier.

Les figures 6 et 7 représentent des exemples de vues de dessus de structures telles que celles illustrées en figures 4A et 5A. Dans le cas de la figure 6, la métallisation connectée à la masse, 40, est disposée de façon centrale et les métallisations 41 destinées à être connectées aux lignes à protéger sont disposées de façon périphérique. Dans le cas de la figure 7, les métallisations 40 reliées à la masse sont en forme de barrettes disposées aux extrémités d'une plaquette rectangulaire alors que les métallisations reliées aux lignes, représentées comme circulaires mais pouvant avoir toute forme choisie, sont disposées entre ces métallisations de masse. On pourra également prévoir un agencement digité.

## Revendications

1. Assemblage monolithique de diodes de protection formé dans un substrat semiconducteur d'un premier type de conductivité, dans lequel :
la première face du substrat (10) comprend des zones discrètes du deuxième type de conductivité opposé au premier dont une première zone (13) est reliée à un potentiel de référence (19) et les autres zones (12-1 ...12-n) forment avec le substrat (10) des diodes et sont reliées à des bornes (18-1 ...18-n) destinées à être connectées à des circuits à protéger, au moins la première zone formant avec le substrat une diode à avalanche ; et
la deuxième face du substrat est uniformément surdopée selon le premier type de conductivité et revêtue d'une métallisation dont le potentiel est flottant (21).

2. Montage de protection, caractérisé en ce qu'il comprend deux assemblages monolithiques (30, 31) selon la revendication 1 montés en parallèle dans lesquels les types de conductivité des zones correspondantes sont mutuellement inversés, les bornes correspondantes étant reliées les unes aux autres sauf les métallisations flottantes.

3. Montage de protection selon la revendication 2, caractérisé en ce que, parmi lesdites zones discrètes, celle (34, 35) reliée au potentiel de référence est dopée de façon à former avec le substrat une diode à avalanche de tension de claquage déterminée, et celles (32, 33) reliées auxdites bornes sont dopées pour former avec le substrat des diodes redresseuses à tension de claquage en inverse plus élevée que ladite tension de claquage déterminée.

4. Montage de protection selon la revendication 3, caractérisé en ce que, pour chaque assemblage monolithique, chaque zone reliée aux bornes est constituée par une première région d'un type de conductivité dans laquelle est incluse une deuxième région du même type de conductivité à plus fort niveau de dopage qui celui de la première région, et en ce que la zone reliée au potentiel de référence a un plus fort niveau de dopage que celui des premières régions.

5. Procédé pour fabriquer un montage de protection selon la revendication 3, caractérisé en ce que, pour chaque assemblage monolithique, les zones reliées aux bornes sont formées par une première étape de diffusion suivie d'une deuxième étape de diffusion à densité de dopant plus élevée au cours de laquelle on forme simultanément la zone reliée au potentiel de référence.

## Claims

1. A monolithic protection diode assembly formed in a semiconductor substrate of a first conductivity type, wherein
the first face of the substrate (10) comprises discrete areas of the second conductivity type opposite to the first one, a first area (13) of which is connected with a reference voltage and the other areas (12-1 ...12-n) form diodes with the substrate and are connected to terminals (18-1 ...18-n) designed for being connected to the circuits to be protected, at least the first area forming an avalanche diode with the substrate; and
the second substrate face is uniformly overdoped with said first conductivity type and coated with a metallization (21) having a floating potential.

2. A protection circuit characterized in that it comprises two parallel-connected monolithic assemblies (30, 31) according to claim 1, wherein the conductivity types of the corresponding areas are mutually reversed, the corresponding terminals being interconnected except for the floating metallizations.

3. A protection circuit according to claim 2, characterized in that, among said discrete areas, the one (34, 35) connected with the reference potential is doped so as to form with the substrate an avalanche diode having a determined breakdown voltage, and those (32, 33) connected to said terminals are doped so as to form with the substrate rectifying diodes with a reverse breakdown voltage higher than said determined breakdown voltage.

4. A protection circuit according to claim 3, characterized in that, for each monolithic assembly, each area connected to the terminals is comprised of a first region of one conductivity type, in which is included a second region of the same conductivity type, with a higher doping level than the first region, and that the area connected to the reference potential has a higher doping level than the first regions.

5. A method for manufacturing a protection circuit according to claim 3, characterized in that, for each monolithic assembly, the areas connected to the terminals are formed by a first diffusion step followed by a second diffusion step having a higher doping density during which the area connected with the reference voltage is simultaneously formed.

## Patentansprüche

1. Monolithische Anordnung von Schutzdioden, die auf einem Halbleitersubstrat eines ersten Leitungstypes ausgebildet sind, wobei
die erste Fläche des Substrates (10) diskrete Zonen des zweiten, zum ersten Leitungstyp entgegengesetzten Leitungstypes aufweist, wobei eine erste Zone (13) an ein Referenzpotential (19) angeschlossen ist und die anderen Zonen (12-1....12-n) mit dem Substrat (10) Dioden bilden und an Anschlüsse (18-1 ....18-n) angeschlossen sind, die zur Verbindung mit zu schützenden Schaltungen bestimmt sind, wobei zumindest die erste Zone mit dem Substrat eine Avalanche-Diode bildet, und
die zweite Fläche des Substrates gleichmäßig mit dem ersten Leitungstyp überdotiert und mit einer Metallisierung mit schwebendem Potential bedeckt ist.

2. Schutzanordnung, dadurch gekennzeichnet, daß sie zwei monolithische Anordnungen (30, 31) nach Anspruch 1 enthält, die parallel geschaltet sind und in denen die Leitungstypen der entsprechenden Zonen wechselseitig invertiert sind, wobei die korrespondierenden Anschlüsse bis auf die schwebenden Metallisierungen gegenseitig miteinander verbunden sind.

3. Schutzanordnung nach Anspruch 2, dadurch gekennzeichnet, daß unter den besagten diskreten Zonen diejenige (34, 35), die an das Referenzpotential angeschlossen ist, derart dotiert ist, um mit dem Substrat eine Avalanche-Diode mit einer bestimmten Durchschlagsspannung zu bilden, und diejenigen (32, 33), die an die besagten Anschlüsse angeschlossen sind, dotiert sind, um mit dem Substrat Gleichrichterdioden mit einer invers gerichteten Durchschlagsspannung zu bilden, die höher als die genannte bestimmte Durchschlagsspannung ist.

4. Schutzanordnung nach Anspruch 3, dadurch gekennzeichnet, daß für jede monolithische Anordnung jede mit den Anschlüssen verbundene Zone durch einen ersten Bereich eines Leitungstypes gebildet ist, in der ein zweiter Bereich des gleichen Leitungstypes mit einem gegenüber dem ersten Bereich höheren Dotierungsniveau eingeschlossen ist, und daß die an das Referenzpotential angeschlossene Zone ein höheres Dotierungsniveau als die ersten Bereiche aufweist.

5. Verfahren zur Herstellung einer Schutzanordnung nach Anspruch 3, dadurch gekennzeichnet, daß für jede monolithische Anordnung die an die Anschlüsse angeschlossenen Zonen durch einen ersten Diffusionsschritt gebildet werden, an den sich ein zweiter Diffusionsschritt mit höherer Dichte des Dotierungsmittels anschließt, in dessen Verlauf gleichzeitig die an das Referenzpotential angeschlossene Zone gebildet wird.
